# EUROPEAN PATENT APPLICATION

(11) **EP 4 415 047 A1**
(43) Date of publication of application: **14.08.2024**
(21) Application number: 22878197.7
(22) Date of filing: 15.08.2022
(51) Int. Cl.: H01L 27/146, H04N 23/12

(54) **IMAGING DEVICE**

(30) Priority: 07.10.2021 JP 2021165691
(71) Applicant: Sony Semiconductor Solutions Corporation, Atsugi-shi, Kanagawa 243-0014 (JP)
(72) Inventor: SEKIGUCHI, Koji, Atsugi-shi, Kanagawa 243-0014 (JP); YOKOCHI, Kaito, Atsugi-shi, Kanagawa 243-0014 (JP); OGASAHARA, Takayuki, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/030903
(87) International publication number: WO 2023/058326

(57) **Abstract**

An imaging device according to an embodiment of the present disclosure includes: a first filter that allows light of a first wavelength band to pass therethrough; a first photoelectric converter that photoelectrically converts the light of the first wavelength band having passed through the first filter; a second filter that is provided adjacent to the first filter, and allows light of a second wavelength band to pass therethrough; and a second photoelectric converter that photoelectrically converts the light of the second wavelength band having passed through the second filter. A refractive index of the first filter for the light of the first wavelength band is higher than a refractive index of the second filter for the light of the first wavelength band.

## Description

### Technical Field

The present disclosure relates to an imaging device.

### Background Art

There has been proposed an imaging device in which an air gap is provided between two color filters adjacent to each other and the air gap has a refractive index lower than refractive indices of the color filters (PTL 1).

### Citation List

### Patent Literature

PTL 1: US Unexamined Patent Application Publication No. 2019/0157329

### Summary of the Invention

An imaging device is desired to efficiently receive incident light.

It is desirable to provide an imaging device that makes it possible to efficiently receive light.

An imaging device according to an embodiment of the present disclosure includes: a first filter that allows light of a first wavelength band to pass therethrough; a first photoelectric converter that photoelectrically converts the light of the first wavelength band having passed through the first filter; a second filter that is provided adjacent to the first filter, and allows light of a second wavelength band to pass therethrough; and a second photoelectric converter that photoelectrically converts the light of the second wavelength band having passed through the second filter. A refractive index of the first filter for the light of the first wavelength band is higher than a refractive index of the second filter for the light of the first wavelength band.

### Brief Description of Drawings

[FIG. 1] FIG. 1 is a block diagram illustrating an example of an overall configuration of an imaging device according to an embodiment of the present disclosure.
[FIG. 2] FIG. 2 is a diagram illustrating an example of a pixel section of the imaging device according to the embodiment of the present disclosure.
[FIG. 3] FIG. 3 is a diagram illustrating an arrangement example of pixels of the imaging device according to the embodiment of the present disclosure.
[FIG. 4] FIG. 4 is a diagram illustrating an example of a cross-sectional configuration of the imaging device according to the embodiment of the present disclosure.
[FIG. 5] FIG. 5 is a diagram illustrating an example of a cross-sectional configuration of an imaging device according to a modification example 1.
[FIG. 6] FIG. 6 is a diagram illustrating an example of a cross-sectional configuration of an imaging device according to a modification example 2.
[FIG. 7] FIG. 7 is a diagram illustrating another example of the cross-sectional configuration of the imaging device according to the modification example 2.
[FIG. 8] FIG. 8 is a diagram illustrating another example of the cross-sectional configuration of the imaging device according to the modification example 2.
[FIG. 9] FIG. 9 is a diagram illustrating an example of a cross-sectional configuration of an imaging device according to a modification example 3.
[FIG. 10] FIG. 10 is a diagram illustrating another example of the cross-sectional configuration of the imaging device according to the modification example 3.
[FIG. 11] FIG. 11 is a diagram illustrating an example of a pixel arrangement of an imaging device according to a modification example 4.
[FIG. 12] FIG. 12 is a diagram illustrating an example of a cross-sectional configuration of the imaging device according to the modification example 4.
[FIG. 13] FIG. 13 is a diagram illustrating another example of the pixel arrangement of the imaging device according to the modification example 4.
[FIG. 14] FIG. 14 is a diagram illustrating another example of the cross-sectional configuration of the imaging device according to the modification example 4.
[FIG. 15] FIG. 15 is a diagram illustrating an example of a pixel arrangement of an imaging device according to a modification example 5.
[FIG. 16] FIG. 16 is a diagram illustrating another example of the pixel arrangement of the imaging device according to the modification example 5.
[FIG. 17] FIG. 17 is a diagram illustrating another example of the pixel arrangement of the imaging device according to the modification example 5.
[FIG. 18] FIG. 18 is a diagram illustrating another example of the pixel arrangement of the imaging device according to the modification example 5.
[FIG. 19] FIG. 19 is a diagram illustrating another example of the pixel arrangement of the imaging device according to the modification example 5.
[FIG. 20] FIG. 20 is a diagram illustrating another example of the pixel arrangement of the imaging device according to a modification example 5.
[FIG. 21] FIG. 21 is a diagram illustrating another example of the pixel arrangement of the imaging device according to the modification example 5.
[FIG. 22] FIG. 22 is a diagram illustrating an example of a pixel arrangement of an imaging device according to a modification example 6.
[FIG. 23] FIG. 23 is a diagram illustrating another example of the pixel arrangement of the imaging device according to the modification example 6.
[FIG. 24] FIG. 24 is a diagram illustrating another example of the pixel arrangement of the imaging device according to the modification example 6.
[FIG. 25] FIG. 25 is a diagram illustrating another example of the pixel arrangement of the imaging device according to the modification example 6.
[FIG. 26] FIG. 26 is a diagram illustrating another example of the pixel arrangement of the imaging device according to the modification example 6.
[FIG. 27] FIG. 27 is a block diagram illustrating a configuration example of an electronic apparatus including an imaging device.
[FIG. 28] FIG. 28 is a block diagram depicting an example of schematic configuration of a vehicle control system.
[FIG. 29] FIG. 29 is a diagram of assistance in explaining an example of installation positions of an outside-vehicle information detecting section and an imaging section.
[FIG. 30] FIG. 30 is a view depicting an example of a schematic configuration of an endoscopic surgery system.
[FIG. 31] FIG. 31 is a block diagram depicting an example of a functional configuration of a camera head and a camera control unit (CCU).

### Modes for Carrying Out the Invention

Some embodiments of the present disclosure are described below in detail with reference to the drawings. It is to be noted that description is given in the following order.
1. Embodiment
2. Modification Examples
2-1. Modification Example 1
2-2. Modification Example 2
2-3. Modification Example 3
2-4. Modification Example 4
2-5. Modification Example 5
2-6. Modification Example 6
3. Application Example
4. Practical Application Examples

### <1. Embodiment>

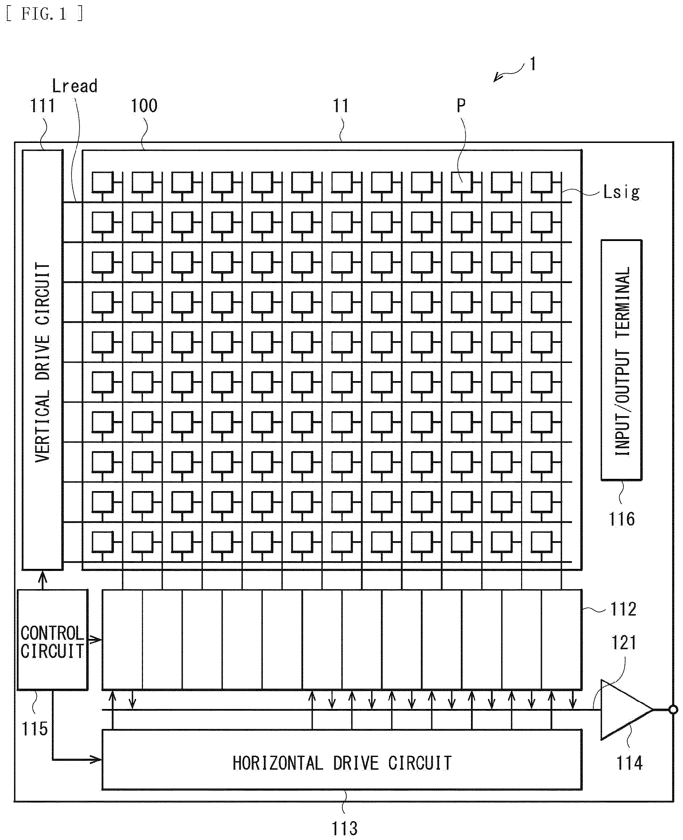

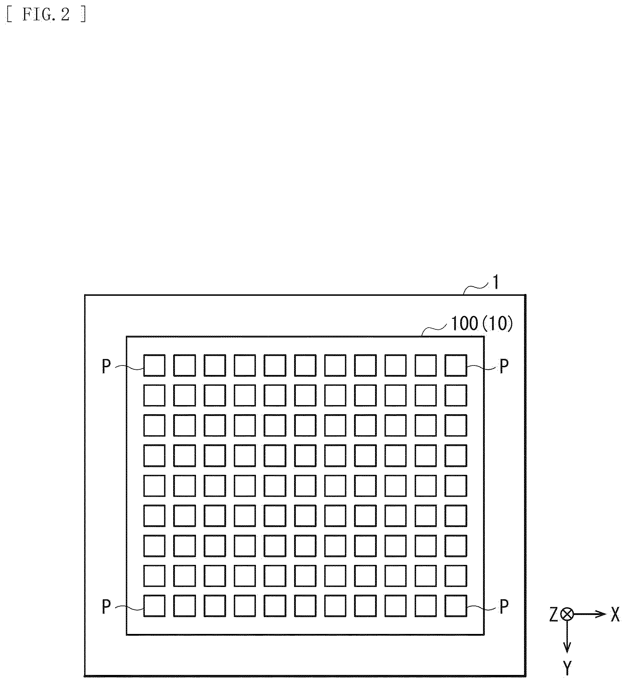

FIG. 1 is a block diagram illustrating an example of an overall configuration of an imaging device (an imaging device 1) according to an embodiment of the present disclosure. FIG. 2 is a diagram illustrating an example of a pixel section of the imaging device 1 according to the embodiment. The imaging device 1 is, for example, a CMOS (Complementary Metal Oxide Semiconductor) image sensor.

In the imaging device 1, pixels P each including a photoelectric converter are arranged in a matrix. As illustrated in FIG. 2, the imaging device 1 includes, as an imaging area, a pixel section 100 in which a plurality of pixels P are two-dimensionally arranged in a matrix. It is possible to use the imaging device 1 for an electronic apparatus such as a digital still camera or a video camera. It is to be noted that, as illustrated in FIG. 2, a direction of incidence of light from a subject is defined as a Z-axis direction, a lateral direction on the sheet orthogonal to the Z-axis direction is defined as an X-axis direction, and a longitudinal direction on the sheet orthogonal to the Z axis and the X axis is defined as a Y-axis direction. In the subsequent drawings, a direction may be expressed with reference to directions of arrows in FIG. 2 in some cases.

### [Schematic Configuration of Imaging Device]

The imaging device 1 takes in incident light (image light) from a subject through an optical lens system (not illustrated). The imaging device 1 captures an image of the subject. The imaging device 1 converts the amount of the incident light of which an image is formed on an imaging plane into electric signals on a pixel-by-pixel basis and outputs the electric signals as pixel signals. The imaging device 1 includes, for example, a vertical drive circuit 111, a column signal processing circuit 112, a horizontal drive circuit 113, an output circuit 114, a control circuit 115, an input/output terminal 116, and the like in a peripheral region of the pixel section 100.

The pixel section 100 includes, for example, the plurality of pixels P that is two-dimensionally arranged in a matrix. The pixel section 100 has, for example, a plurality of rows each including a plurality of pixels P disposed side by side in a horizontal direction (the lateral direction on the sheet) and a plurality of columns each including a plurality of pixels P disposed side by side in a vertical direction (the longitudinal direction on the sheet).

In the pixel section 100, for example, pixel drive lines Lread (row selection lines and reset control lines) are wired with respective pixel rows, and vertical signal lines Lsig are wired with respective pixel columns. The pixel drive lines Lread are for transmitting drive signals for signal reading from the pixels. The pixel drive lines Lread each have one end coupled to a corresponding one of output ends, corresponding to the respective pixel rows, of the vertical drive circuit 111.

The vertical drive circuit 111 includes a shift register, an address decoder, and the like. The vertical drive circuit 111 is a pixel driving section that drives the respective pixels P in the pixel section 100, for example, on a row-by-row basis. The column signal processing circuit 112 includes an amplifier, a horizontal selection switch, and the like that are provided for each of the vertical signal lines Lsig. Signals outputted from the respective pixels P in the pixel rows selectively scanned by the vertical drive circuit 111 are supplied to the column signal processing circuit 112 through the respective vertical signal lines Lsig.

The horizontal drive circuit 113 includes a shift register, an address decoder, and the like, and drives respective horizontal selection switches of the column signal processing circuits 112 in sequence while scanning the horizontal selection switches. Such selective scanning by the horizontal drive circuit 113 causes the signals of the respective pixels transmitted through the respective vertical signal lines Lsig to be outputted in sequence to a horizontal signal line 121 and be transmitted to outside of a semiconductor substrate 11 through the horizontal signal line 121.

The output circuit 114 performs signal processing on the signals supplied in sequence from the respective column signal processing circuits 112 through the horizontal signal line 121, and outputs the processed signals. The output circuit 114 performs, for example, only buffering in some cases and performs black level adjustment, column variation correction, various kinds of digital signal processing, and the like in other cases.

The circuit portions including the vertical drive circuit 111, the column signal processing circuits 112, the horizontal drive circuit 113, the horizontal signal line 121, and the output circuit 114 may be formed in the semiconductor substrate 11, or may be provided in an external control IC. Alternatively, these circuit portions may be formed in any other substrate coupled by a cable or the like.

The control circuit 115 receives a clock given from the outside of the semiconductor substrate 11, data for an instruction about an operation mode, and the like, and also outputs data such as internal information of the imaging device 1. The control circuit 115 further includes a timing generator that generates various timing signals, and performs drive control of peripheral circuits such as the vertical drive circuit 111, the column signal processing circuit 112, and the horizontal drive circuit 113 on the basis of the various timing signals generated by the timing generator. The input/output terminal 116 exchanges signals with the outside.

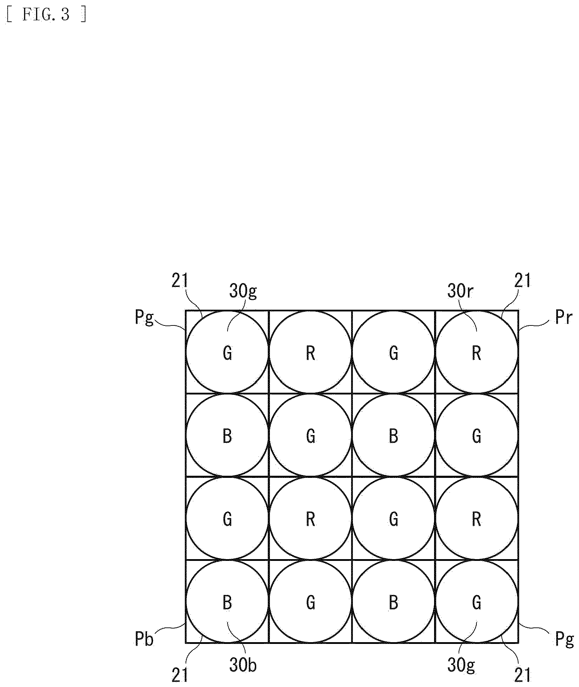

FIG. 3 is a diagram illustrating an arrangement example of pixels of the imaging device 1 according to the embodiment. The pixels P of the imaging device 1 each include a lens section 21 that condenses light, and a color filter 30 (a color filter 30r, 30g, or 30b in FIG. 3). The color filter 30 allows light of a specific wavelength band out of the incident light to selectively pass therethrough. The plurality of pixels P provided in the pixel section 100 of the imaging device 1 includes, for example, a plurality of pixels Pr, a plurality of pixels Pg, and a plurality of pixels Pb, as illustrated in FIG. 3.

The pixels Pr are pixels each provided with the color filter 30r that allows red (R) light to pass therethrough. The pixels Pg are pixels each provided with the color filter 30g that allows green (G) light to pass therethrough. In addition, the pixels Pb are pixels each provided with the color filter 30b that allows blue (B) light to pass therethrough. The pixels Pr, the pixels Pg, and the pixels Pb are arranged, for example, in what is called a Bayer arrangement. The pixels Pr, the pixels Pg, and the pixels Pb respectively generate pixel signals of an R component, pixel signals of a G component, and pixel signals of a B component. This makes it possible for the imaging device 1 to obtain pixel signals of RGB.

It is to be noted that the color filters 30 are not limited to color filters of primary colors (RGB), and may include color filters of complementary colors such as Cy (cyan), Mg (magenta), or Ye (yellow). In addition, a color filter corresponding to W (white), that is, a filter that allows light of an entire wavelength band out of the incident light to pass therethrough may be provided.

### [Configuration of Pixel]

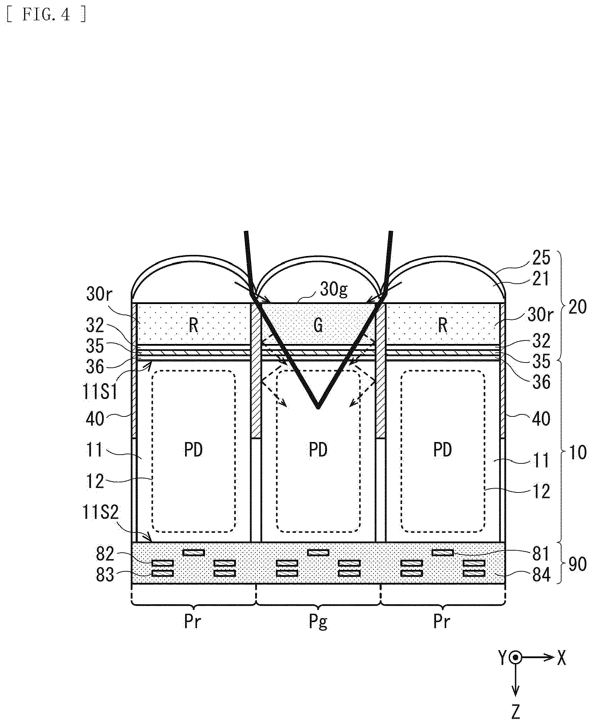

FIG. 4 is a diagram illustrating an example of a cross-sectional configuration of the imaging device 1 according to the embodiment. The imaging device 1 has, for example, a configuration in which a light-receiving section 10, a light-guiding section 20, and a multilayer wiring layer 90 are stacked in the Z-axis direction. The light-receiving section 10 includes the semiconductor substrate 11 having a first surface 11S1 and a second surface 11S2 that are opposed to each other. The light-guiding section 20 is provided on side of the first surface 11S1 of the semiconductor substrate 11, and the multilayer wiring layer 90 is provided on side of the second surface 11S2 of the semiconductor substrate 11. It can be said that the light-guiding section 20 is provided on side where light from the optical lens system enters, and the multilayer wiring layer 90 is provided on side opposite to the side where the light enters. The imaging device 1 is what is called a back-illuminated imaging device.

The semiconductor substrate 11 includes, for example, a silicon substrate. A photoelectric converter 12 is, for example, a photodiode (PD), and includes a pn junction in a predetermined region of the semiconductor substrate 11. A plurality of photoelectric converters 12 is formed so as to be embedded in the semiconductor substrate 11. In the light-receiving section 10, the plurality of photoelectric converters 12 is provided along the first surface 11S1 and the second surface 11S2 of the semiconductor substrate 11.

The multilayer wiring layer 90 has, for example, a configuration in which a plurality of wiring layers 81, 82, and 83 is stacked with an interlayer insulating layer 84 interposed therebetween. A circuit (such as a transfer transistor, a reset transistor, or an amplification transistor) for reading a pixel signal based on an electric charge generated by the photoelectric converter 12 is formed in the semiconductor substrate 11 and the multilayer wiring layer 90. In addition, for example, the vertical drive circuit 111, the column signal processing circuit 112, the horizontal drive circuit 113, the output circuit 114, the control circuit 115, and the input/output terminal 116 described above, and the like are formed in the semiconductor substrate 11 and the multilayer wiring layer 90.

The wiring layers 81, 82, and 83 of the multilayer wiring layer 90 are formed with use of, for example, aluminum (Al), copper (Cu), tungsten (W), or the like. The wiring layers 81, 82, and 83 may be formed with use of polysilicon (poly-Si). The interlayer insulating layer 84 includes a single-layer film including one kind from among silicon oxide (SiOₓ), silicon nitride (SiNₓ), silicon oxynitride (SiOₓN_{y}), and the like, or includes a stacked film including two or more kinds from among these materials.

The light-guiding section 20 includes, for example, the lens section 21 and the color filter 30 described above, and a light-guiding member 32, and guides light incident from above in FIG. 4 to side of the light-receiving section 10. FIG. 4 illustrates the pixel Pg having the color filter 30g of G and the pixel Pr having the color filter 30r of R. The light-guiding section 20 is stacked on the light-receiving section 10 in a thickness direction orthogonal to the first surface 11S1 of the semiconductor substrate 11.

The lens section 21 is an optical member also called an on-chip lens, and is provided above the color filter 30 for each pixel or for every two or more pixels. Light from the subject enters the lens section 21 through, for example, an optical lens system such as an imaging lens. A first antireflective film 25 for suppressing reflection is provided on a top surface, that is, a surface on light incidence side, of the lens section 21. The first antireflective film 25 includes, for example, a LTO (Low Temperature Oxide) film, and reduces reflection. It is to be noted that the first antireflective film 25 may be configured with use of silicon oxynitride, aluminum oxide (AlO), titanium oxide (TiO), or the like, or may be configured with use of any other material.

The lens section 21 includes a material having a high refractive index, for example, a material having a refractive index higher than a refractive index of silicon dioxide (SiOz). For example, the lens section 21 includes silicon nitride. It is to be noted that the lens section 21 may be configured with use of any other nitride dielectric. The lens section 21 may include a resin, or may be configured with use of any other material.

A height in the Z-axis direction of the lens section 21, that is, a thickness in the Z-axis direction of the lens section 21 is set so as to condense, to the photoelectric converter 12, light that is to enter the lens section 21. As indicated by a thick arrow in FIG. 4, for example, the height of the lens section 21 is set low (small) in accordance with the refractive index of the lens section 21 so as to condense light to the photoelectric converter 12. An interval between the lens section 21 and the photoelectric converter 12 is shortened, which makes it possible to efficiently condense light to the photoelectric converter 12. Reducing the height of the lens section 21 makes it possible to condense light to the color filter 30 and the photoelectric converter 12 before light having passed through the lens section 21 spreads.

The light-guiding member 32 is provided between the color filter 30 and the photoelectric converter 12. The light-guiding member 32 includes, for example, silicon dioxide. The light-guiding member 32 may include a material having a refractive index higher than the refractive index of silicon dioxide, for example, a nitride dielectric such as silicon nitride. Providing the light-guiding member 32 between the color filter 30 and the photoelectric converter 12 makes it possible to condense more light to the photoelectric converter 12.

The light-guiding member 32 may include any other high refractive index material. It is to be noted that the light-guiding member 32 may not be provided in the imaging device 1. For example, in a case where light condensation performance is sufficient, the light-guiding member 32 may not be provided.

The imaging device 1 may include a second antireflective film 35 and a fixed electric charge film 36 between the light-guiding member 32 and the photoelectric converter 12 as with the example illustrated in FIG. 4. The fixed electric charge film 36 includes, for example, aluminum oxide, and is provided on the semiconductor substrate 11. The fixed electric charge film 36 is a film having a negative fixed electric charge, and suppresses generation of a dark current at an interface of the semiconductor substrate 11. It is to be the fixed electric charge film 36 may be configured with use of any other metal oxide such as tantalum oxide, or may be configured with use of any other material. As the fixed electric charge film 36, a film having a positive fixed electric charge may be provided.

The second antireflective film 35 includes, for example, tantalum oxide. The second antireflective film 35 is provided between the light-guiding member 32 and the fixed electric charge film 36, and reduces reflection. The second antireflective film 35 may include metal oxide film other than tantalum oxide. Alternatively, the second antireflective film 35 may include an insulating material such as a silicon oxide film, or may be configured with use of any other material. It is to be noted that the light-guiding section 20 described above may include the second antireflective film 35 and the fixed electric charge film 36.

An isolator 40 is provided between the color filters 30 adjacent to each other, and separates the color filters 30 from each other. The isolator 40 has a refractive index lower than a refractive index of a surrounding medium. The isolator 40 has, for example, a hollow (an air gap). The isolator 40 has a trench structure provided at a boundary between the pixels P adjacent to each other, and is also called a inter-pixel isolator or an inter-pixel separation wall. The isolator 40 is provided at each of a boundary between the pixel Pr and the pixel Pg, a boundary between the pixel Pg and the pixel Pb, and a boundary between the pixel Pr and the pixel Pb.

The isolator 40 may be formed so as to reach at least the first surface 11S1 of the semiconductor substrate 11. In the example illustrated in FIG. 4, the isolator 40 is provided from between the color filters 30 adjacent to each other to between the photoelectric converters 12 adjacent to each other in the semiconductor substrate. The imaging device 1 includes the isolator 40 around each of the color filters 30, the light-guiding member 32, the second antireflective film 35, the fixed electric charge film 36, and the photoelectric converters 12. A portion of the isolator 40 is positioned on side portions of the color filters 30, and is formed so as to surround the color filters 30.

The isolator 40 changes a traveling direction of incident light by a refractive index difference between the isolator 40 and its surrounding medium. As indicated by a dashed arrow in FIG. 4, a part of light having passed through the lens section 21 is reflected by the isolator 40 and guided toward the photoelectric converter 12. It is possible to propagate the incident light to the photoelectric converter 12, and it is possible to suppress leakage of the light to surrounding pixels. It can be said that the imaging device 1 has a waveguide structure that guides light to the photoelectric converter 12 by the isolator 40. It is to be noted that the isolator 40 may include a resin or an oxide film. Alternatively, the isolator 40 may be formed by filling a trench with a filler including silica (SiO₂), or may include any other material.

In a case where in a wavelength band of incident light, a refractive index of a certain color filter is lower than a refractive index of another color filter positioned adjacent to the certain color filter, there is a possibility that it is not possible to appropriately guide light to a photoelectric converter provided for the certain color filter. It may not be possible to efficiently guide light to the photoelectric converter, and quantum efficiency (QE) may decrease. In addition, there is a possibility that a part of light having entered the certain pixel is leaked to other pixels adjacent to the certain pixel, thereby causing color mixture. For example, if a refractive index of a green filter of a G (green) pixel in a green wavelength band is lower than a refractive index of a red filter of a R (red) pixel adjacent to the G pixel, there is a possibility that a part of light having entered the G pixel is leaked to the R pixel. In this case, it is conceivable that a decrease in quantum efficiency of the G pixel and color mixture between the G pixel and the R pixel are caused. In particular, in a case of fine pixels, there is a tendency that a decrease in quantum efficiency and color mixture are easily caused.

Accordingly, in the present embodiment, for light of a specific wavelength band that passes through each color filter 30, the color filter 30 has a refractive index higher than refractive indices of other color filters 30 that are disposed around the color filter 30 and have a color different from the color of the color filter 30. The refractive index of a certain color filter 30 for light of a specific wavelength band to be allowed by the certain color filter 30 to pass therethrough is higher than the refractive indices of the color filters 30 of other colors for the light of the specific wavelength band. For example, for light of a green light wavelength band, the color filter 30g has a refractive index higher than a refractive index of the color filter 30r for the light of the green light wavelength band. Accordingly, in the present embodiment, it is possible to suppress leakage of light to surrounding pixels and appropriately guide the light to the photoelectric converter 12.

The color filter 30 has a refractive index higher than the refractive index of the color filter 30 of a different color over a wavelength band of light that is to pass therethrough, which makes it possible to suppress a decrease in the amount of light that is to enter the photoelectric converter 12 and prevent a decrease in sensitivity to incident light. It is possible to enhance quantum efficiency, and it is possible to suppress occurrence of color mixture. Thus, it is possible to prevent a decrease in image quality of an image.

In one example, the refractive index of the color filter 30 is adjusted by adding a high refractive index material to a pigment that is a material of the color filter 30. For example, the color filter 30 having a high refractive index is formed by using a material mixed with a filler having a high refractive index (e.g., titanium oxide). The refractive index of the color filter 30 increases or decreases in accordance with the content of a high refractive index filler. The color filter 30 is formed so as to have, for example, a refractive index higher than the refractive index of silicon dioxide (SiOz).

In the present embodiment, the content of the filler may be adjusted so as to cause the refractive index of each of the color filter 30r, the color filter 30g, and the color filter 30b to have a desired value. Each of the color filter 30r, the color filter 30g, and the color filter 30b is formed so as to have, for example, a refractive index higher by 0.05 or more than the refractive index of silicon dioxide (SiO₂) in a wavelength band from 400 nm to 700 nm. Each of the color filter 30r, the color filter 30g, and the color filter 30b may be formed so as to have a refractive index higher by 0.4 or more than the refractive index of the isolator 40.

The color filter 30 having a high refractive index makes it possible to relatively increase a refractive index difference between the color filter 30 and the isolator 40 for a waveguide. Accordingly, also in a case where the lens section 21 has a relatively low refractive index, or also in a case where an opening of the pixel has a size equal to or less than a diffraction limit of light, it is possible to guide light to a desired pixel. In addition, it is possible to collect light from a range larger than or equal to a pixel size, and it is possible to further enhance quantum efficiency of a desired pixel.

A height (thickness) in the Z-axis direction of each of the color filters 30 and the light-guiding member 32 is adjusted so as to cause light to be condensed to the photoelectric converter 12. For example, the height of each of the color filters 30 and the light-guiding member 32 is set low so as to cause light to be efficiently condensed to the photoelectric converter 12.

Light absorption characteristics of the color filters 30 are adjusted by, for example, the concentration of a pigment. Using a highly concentrated pigment makes it possible to achieve the color filter 30 having high absorption characteristics. Reducing the height of the color filter 30 including the highly concentrated pigment makes it possible to suppress color mixture to adjacent pixels of other colors while maintaining the light absorption characteristics.

In the present embodiment, in one example, the color filter 30g has a characteristic in which the refractive index thereof is higher than that of the color filter 30r at a wavelength of green light. The refractive index of the color filter 30g for light at a green wavelength is higher than the refractive index of the color filter 30r for the light at the green wavelength over the green wavelength band, for example, a wavelength range from 500 nm to 550 nm. The color filter 30g may be formed so as to have, for example, a refractive index higher by 0.05 or more than the refractive index of the color filter 30r in an entire wavelength band from 500 nm to 550 nm.

In FIG. 4, light of the green wavelength band having entered the lens section 21 of the pixel Pg from above travels to the photoelectric converter 12 below the color filter 30g through the color filter 30g having a relatively high refractive index out of the color filter 30g and the color filter 30r adjacent to each other. In addition, green wavelength light having entered an end, on side of the pixel Pg, of the lens section 21 of the pixel Pr also travels to the color filter 30g and the photoelectric converter 12 of the pixel Pg in accordance with a refractive index difference between the color filter 30g and the color filter 30r, as indicated by the thick arrow in FIG. 4.

Thus, it is possible to guide the incident green wavelength light to the color filter 30g and the photoelectric converter 12 of the pixel Pg. The photoelectric converter 12 of the pixel Pg is allowed to efficiently receive and photoelectrically convert the green wavelength light. This makes it possible to improve quantum efficiency in the pixel Pg. In addition, it is possible to suppress occurrence of color mixture between the pixel Pg and the pixel Pr adjacent to each other.

In addition, the color filter 30g has a characteristic in which the refractive index thereof is higher than that of the color filter 30b at the wavelength of green light. The refractive index of the color filter 30g for light at the green wavelength is higher than the refractive index of the color filter 30b for the light at the green wavelength over the green wavelength band, for example, the wavelength range from 500 nm to 550 nm. The color filter 30g may be formed so as to have a refractive index higher by 0.05 or more than the refractive index of the color filter 30b in an entire band from 500 nm to 550 nm.

The refractive index of the color filter 30g for the light of the green wavelength band is higher than the refractive index of the color filter 30b, which makes it possible to guide the incident green wavelength light to the color filter 30g and the photoelectric converter 12 of the pixel Pg. Accordingly, it is possible to improve quantum efficiency in the pixel Pg. In addition, it is possible to suppress occurrence of color mixture between the pixel Pg and the pixel Pb adjacent to each other. Thus, in the present embodiment, it is possible to enhance sensitivity of the imaging device 1 to green light with consideration of sensitivity of human eyes, and it is possible to improve image quality.

It is to be noted that the color filter 30g may be formed so as to have a refractive index higher than those of the color filter 30r and the color filter 30b in a specific wavelength range of the green light. For example, the color filter 30g may be formed so as to have a refractive index higher than the refractive indices of the color filter 30r and the color filter 30b at least in a wavelength range from 510 nm to 540 nm.

In addition, in one example, the color filter 30b has a characteristic in which the refractive index thereof is higher than that of the color filter 30r at a wavelength of blue light. The refractive index of the color filter 30b for light at a blue wavelength is higher than the refractive index of the color filter 30r for the light at the blue wavelength over a blue wavelength band, for example, a wavelength range from 430 nm to 480 nm. The color filter 30b may be formed so as to have, for example, a refractive index higher by 0.05 or more than the refractive index of the color filter 30r in an entire wavelength band from 430 nm to 480 nm.

Light of the blue wavelength band having entered the lens section 21 of the pixel Pb travels to the photoelectric converter 12 below the color filter 30b through the color filter 30b having a relatively high refractive index out of the color filter 30b and the color filter 30r adjacent to each other. In addition, blue wavelength light having entered an end, on side of the pixel Pb, of the lens section 21 of the pixel Pr also travels to the color filter 30b and the photoelectric converter 12 of the pixel Pb in accordance with a refractive index difference between the color filter 30b and the color filter 30r.

Thus, it is possible to guide the incident blue wavelength light to the color filter 30b and the photoelectric converter 12 of the pixel Pb. The photoelectric converter 12 of the pixel Pb is allowed to efficiently receive and photoelectrically convert the blue wavelength light. This makes it possible to improve quantum efficiency in the pixel Pb. In addition, it is possible to suppress occurrence of color mixture between the pixel Pb and the pixel Pr.

It is to be noted that the color filter 30b may be formed so as to have a refractive index higher than that of the color filter 30r in a specific wavelength range of blue light. For example, the color filter 30b may be formed so as to have a refractive index higher than the refractive index of the color filter 30r at least in a wavelength range from 420 nm to 470 nm.

### [Workings and Effects]

The imaging device 1 according to the present embodiment includes a first filter (e.g., the G color filter 30g) that allows light of a first wavelength band to pass therethrough, a first photoelectric converter (the photoelectric converter 12) that photoelectrically converts the light of the first wavelength band having passed through the first filter, a second filter (e.g., the R color filter 30r) that is provided adjacent to the first filter and allows light of a second wavelength band to pass therethrough, and a second photoelectric converter that photoelectrically converts the light of the second wavelength band having passed through the second filter. A refractive index of the first filter for the light of the first wavelength band is higher than a refractive index of the second filter for the light of the first wavelength band.

In the imaging device 1 according to the embodiment, the color filter 30g of the pixel Pg has a refractive index higher than that of the color filter 30r of the pixel Pr in the green wavelength band. Accordingly, it is possible to guide the incident green wavelength light to the color filter 30g and the photoelectric converter 12 of the pixel Pg, and it is possible to improve quantum efficiency. In addition, it is possible to suppress occurrence of color mixture between pixels adjacent to each other.

Next, description is given of modification examples of the present disclosure. Hereinafter, components similar to those in the embodiment described above are denoted by the same reference numerals, and description thereof is omitted as appropriate.

### <2. Modification Examples>

### (2-1. Modification Example 1)

In the embodiment described above, an example has been described in which the color filter 30 having a high refractive index is achieved by using the high refractive index filler; however, a method of achieving the color filter 30 having a high refractive index is not limited thereto. For example, a structure having a high refractive index may be provided.

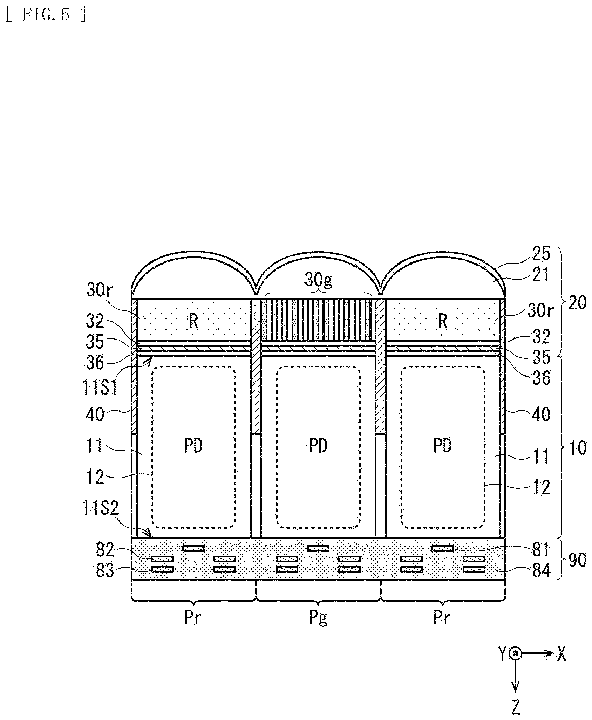

FIG. 5 is a diagram illustrating an example of a cross-sectional configuration of the imaging device 1 according to a modification example 1. In the example illustrated in FIG. 5, the color filter 30g has a plurality of columnar, that is, pillar structures. The structure has a size less than or equal to a predetermined wavelength of incident light, for example, a size less than or equal to a wavelength of visible light, and has a high refractive index. Providing the structure having a high refractive index in the color filter 30g makes it possible to increase the refractive index of the color filter 30g. The refractive index of the color filter 30g is adjusted by the size, shape, refractive index, or the like of each structure. It is to be noted that the structure having a high refractive index may be provided in the color filter 30b and the color filter 30r.

Also in the present modification example, it is possible to provide the color filter 30 having a high refractive index in the imaging device 1, and it is possible to appropriately guide light to a desired pixel. In addition, it is possible to collect light from the range larger than or equal to the pixel size, and it is possible to improve quantum efficiency of a desired pixel.

### (2-2. Modification Example 2)

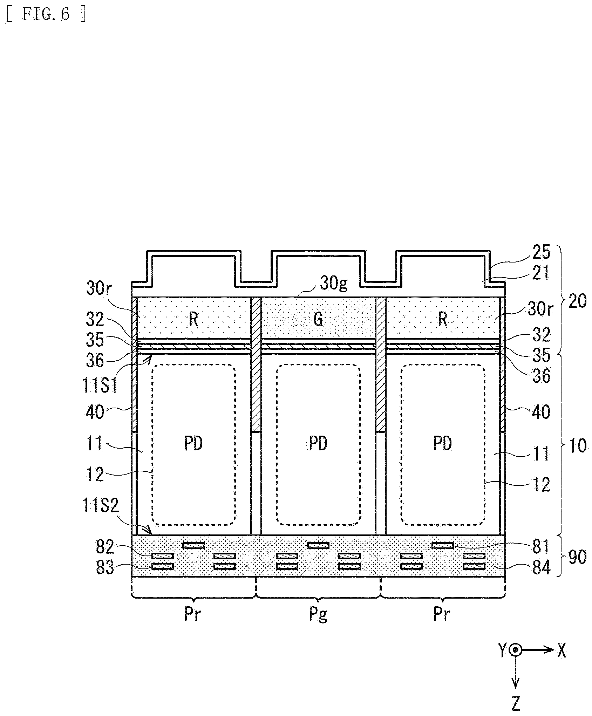

In the embodiment described above, the configuration example of the lens section 21 has been illustrated. However, the configuration example is only one example, and the configuration of the lens section 21 is not limited to the example described above. The configuration of the lens section 21 may be modified as appropriate, and may be, for example, a rectangular lens (a digital lens) as with an example illustrated in FIG. 6. The lens section 21 may be embedded in a layer.

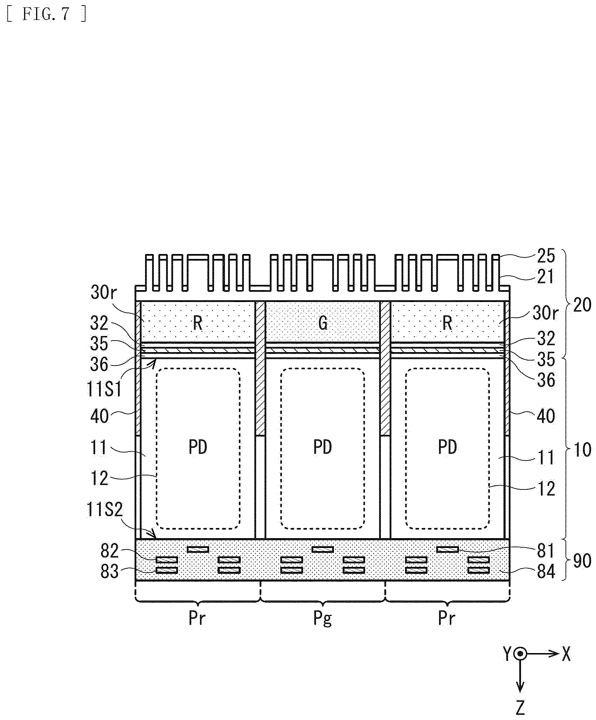

FIG. 7 is a diagram illustrating another example of a cross-sectional configuration of the imaging device 1 according to a modification example 2. As illustrated in FIG. 7, the lens section 21 may have a shape having a plurality of structures. The structures are fine (extremely small) structures each having a size less than or equal to a predetermined wavelength of incident light, for example, a size less than or equal to a wavelength of visible light. The structures each have a refractive index higher than a refractive index of a surrounding medium. The medium around the structures is air (an air gap), silicon oxide, or the like. The structures are, for example, columnar structures. The plurality of structures is disposed in the lateral direction on the sheet (the X-axis direction).

The lens section 21 is able to change the traveling direction of incident light and condense the light by a refractive index difference between fine structures and their surroundings. It can be said that the lens section 21 is a light condensing section (a light condensing element) that condenses light with use of a metamaterial (metasurface) technology.

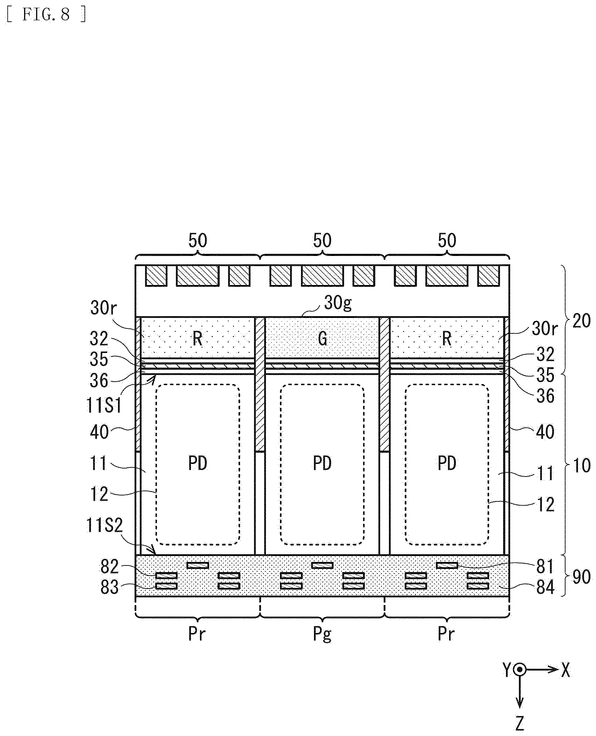

It is to be noted that instead of or in addition to the lens section 21, a splitter 50 such as an example illustrated in FIG. 8 may be provided. The splitter 50 has a plurality of fine structures having different sizes, shapes, or the like. In the splitter 50, a phase delay amount differing depending on a wavelength of light is generated, thereby changing a propagation direction of light for each wavelength band. The splitter 50 is able to separate incident light into pieces of light of respective wavelength bands, and guide the pieces of light of respective wavelength bands to the color filters 30 of respective colors. Also in the present modification example, it is possible to appropriately condense light to the photoelectric converter 12.

### (2-3. Modification Example 3)

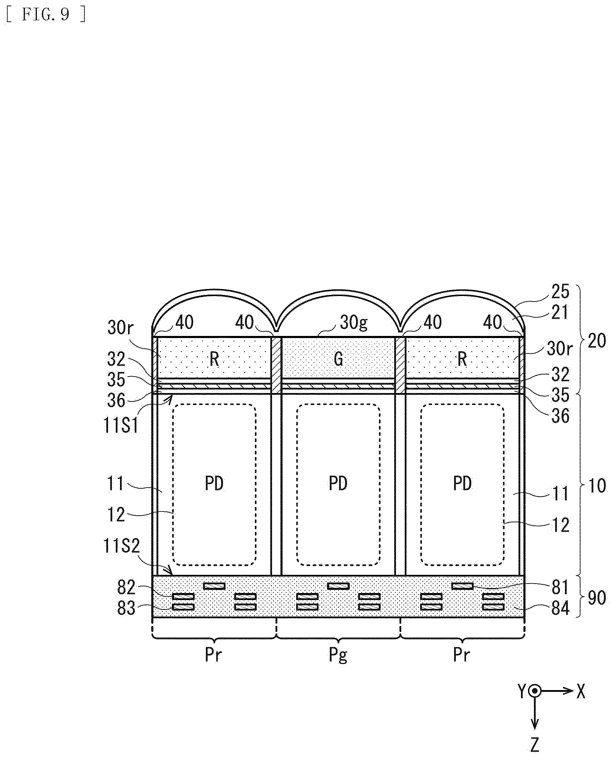

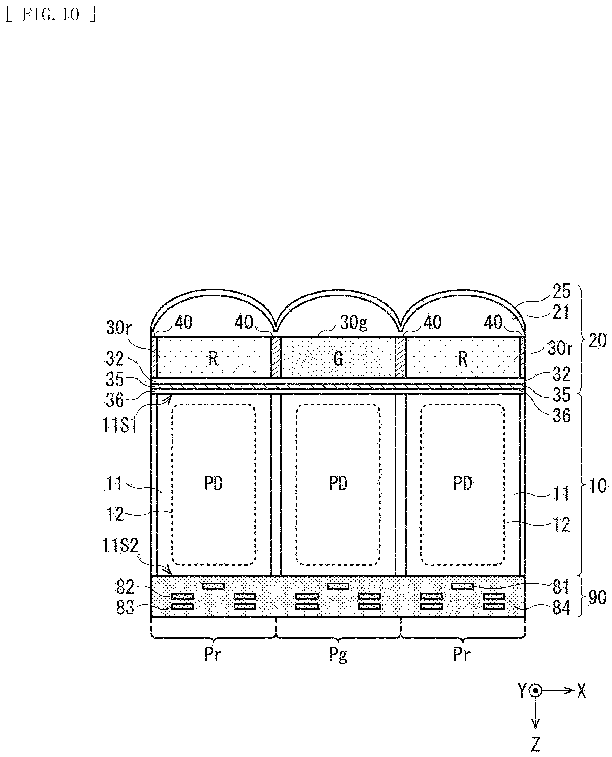

Each of FIGs. 9 and 10 is a diagram illustrating a cross-sectional configuration example of the imaging device 1 according to a modification example 3. As with an example illustrated in FIG. 9, the isolator 40 may be formed from between the color filters 30 adjacent to each other to the first surface 11S1 of the semiconductor substrate 11. Alternatively, as with an example illustrated in FIG. 10, the isolator 40 may be provided only between the color filters 30. Providing the isolator 40 makes it possible to guide incident light to the photoelectric converter 12, and makes it possible to suppress leakage of light to surrounding pixels.

### (2-4. Modification Example 4)

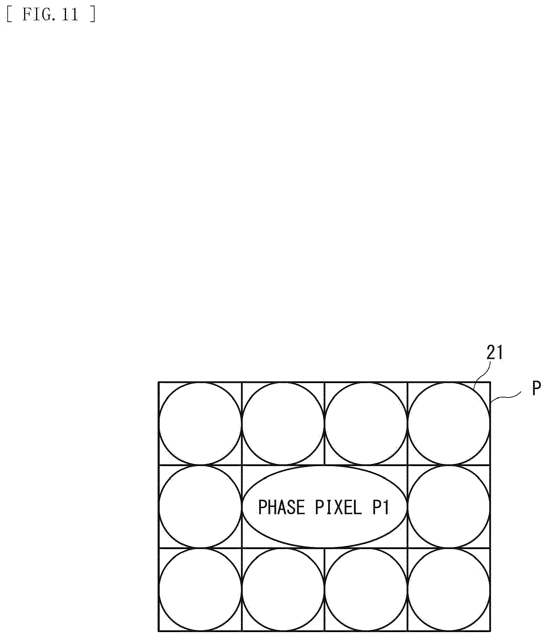

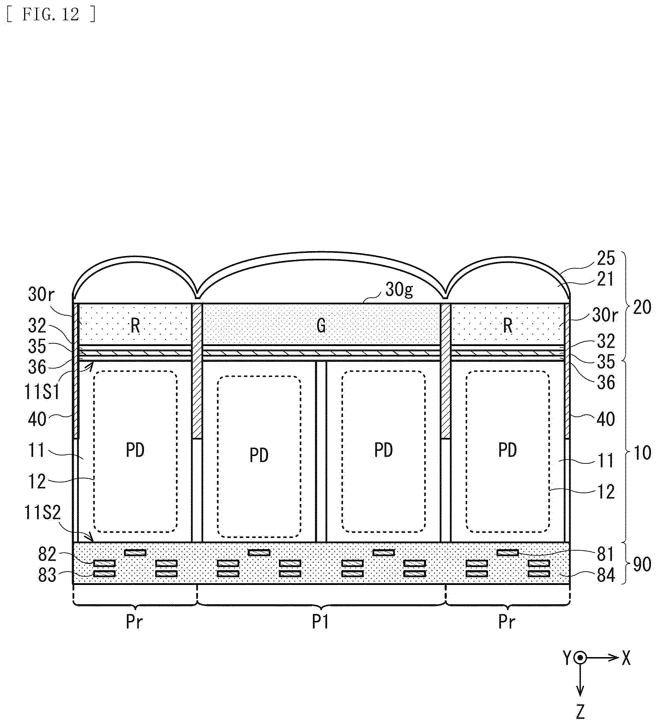

FIG. 11 is a diagram illustrating an example of a pixel arrangement of the imaging device 1 according to a modification example 4. FIG. 12 is a diagram illustrating an example of a cross-sectional configuration of the imaging device 1 according to the modification example 4. FIGs. 11 and 12 each illustrate an example of a phase pixel P1 that is a pixel for phase difference detection provided in the imaging device 1. The phase pixel P1 is provided for 2 × 1 pixels, and includes two photoelectric converters 12.

One lens section 21 is provided for the left and right photoelectric converters 12 of the phase pixel P1. The left and right photoelectric converters 12 receive pieces of light having passed through different regions of an optical lens system such as an imaging lens, and perform pupil division. Accordingly, a pixel signal based on an electric charge photoelectrically converted by one of the photoelectric converters 12 and a pixel signal based on an electric charge photoelectrically converted by the other photoelectric converter 12 are used, which makes it possible to obtain phase difference information, and makes it possible to perform phase difference AF (Auto Focus).

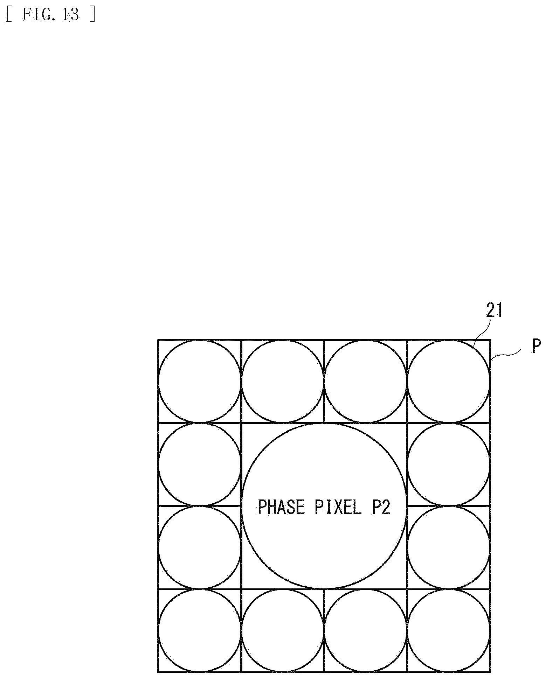

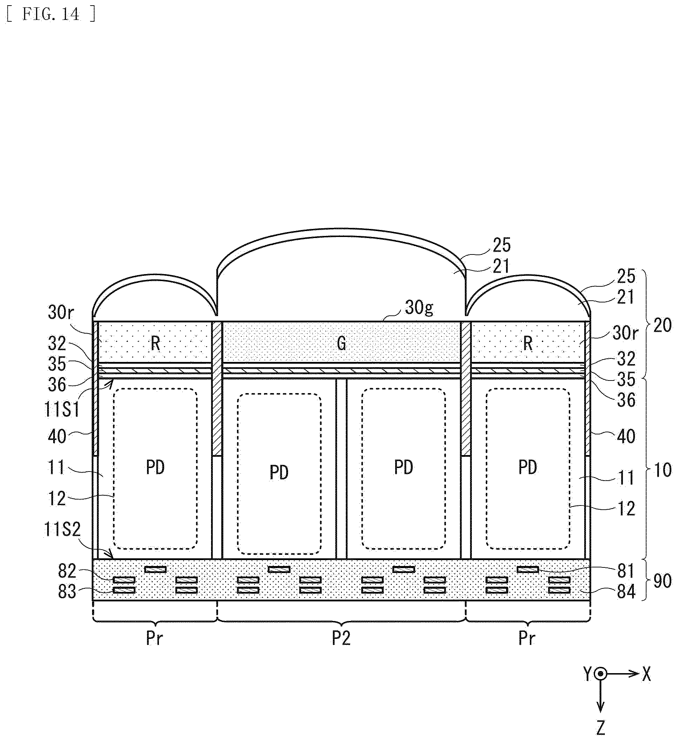

FIG. 13 is a diagram illustrating another example of the pixel arrangement of the imaging device 1 according to the modification example 4. FIG. 14 is a diagram illustrating another example of the cross-sectional configuration of the imaging device 1 according to the modification example 4. In the examples illustrated in FIGs. 13 and 14, a phase pixel P2 is provided for 2 × 2 pixels, and the phase pixel P2 includes four photoelectric converters 12. It is to be noted that heights in the Z-axis direction of the lens sections 21 of the phase pixel P2 and the phase pixel P1 may be different from heights in the Z-axis direction of the lens sections 21 of other pixels (pixels Pr, Pg, and Pb). For example, the height of the lens section 21 of the phase pixel P2 may increase as illustrated in FIG. 14 so as to appropriately perform pupil division.

### (2-5. Modification Example 5)

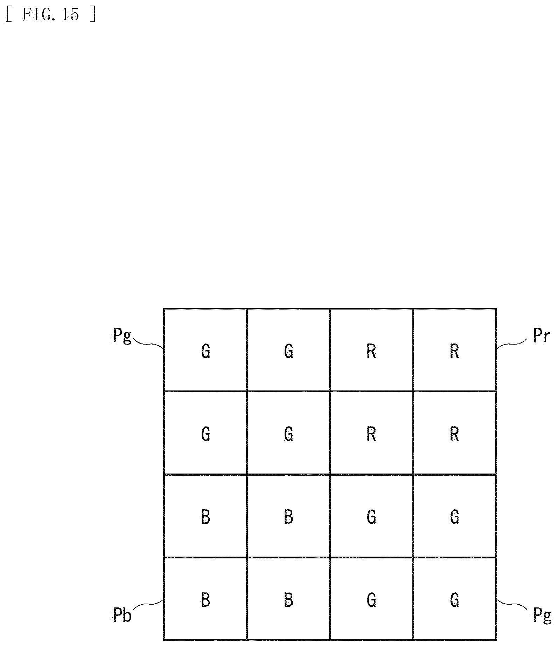

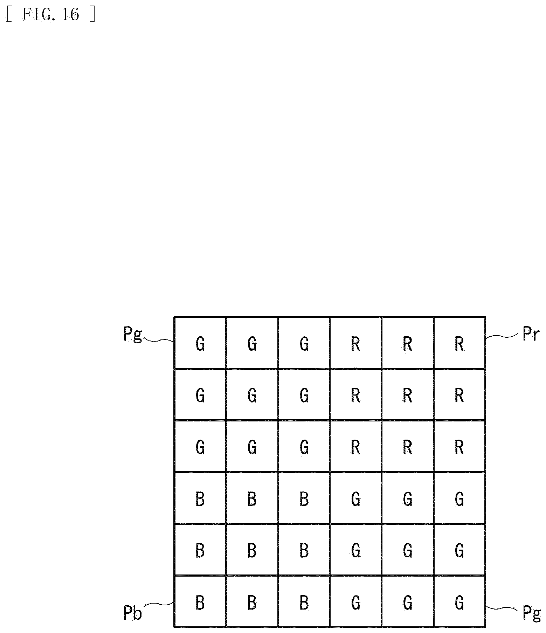

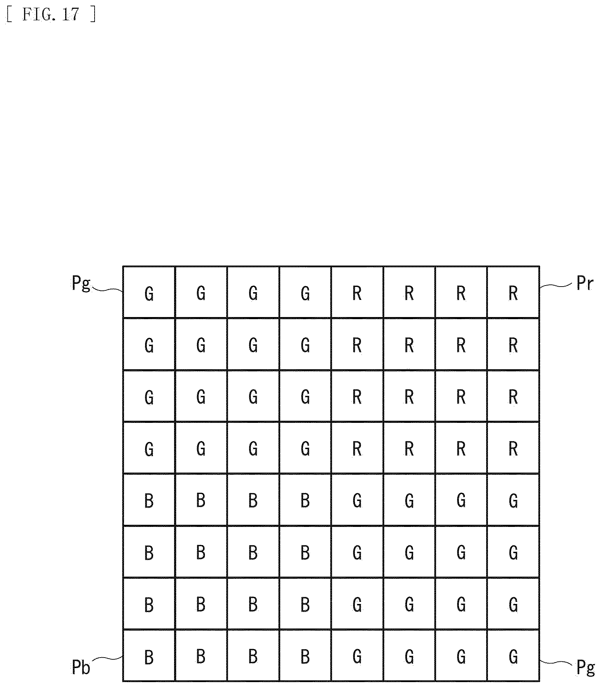

In the embodiment described above, an example has been described in which the pixels Pr, the pixels Pg, and the pixels Pb are arranged in a Bayer arrangement; however, the arrangement of pixels is not limited thereto. For example, as illustrated in FIG. 15, four pixels Pr in 2 × 2, four pixels Pg in 2 × 2, and four pixels Pb in 2 × 2 may be arranged in a Bayer arrangement. As illustrated in FIG. 16, nine pixels Pr in 3 × 3, nine pixels Pb in 3 × 3, and nine pixels Pb in 3 × 3 may be repeatedly arranged. Alternatively, as illustrated in FIG. 17, sixteen pixels Pr in 4 × 4, sixteen pixels Pg in 4 × 4, and sixteen pixels Pb in 4 × 4 may be repeatedly arranged.

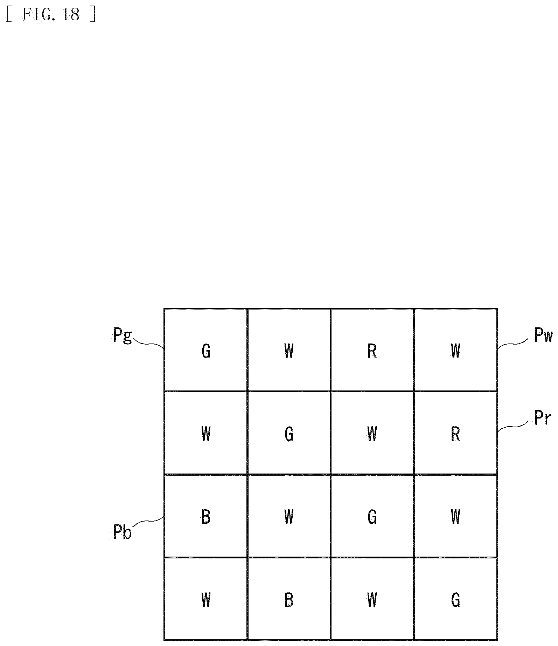

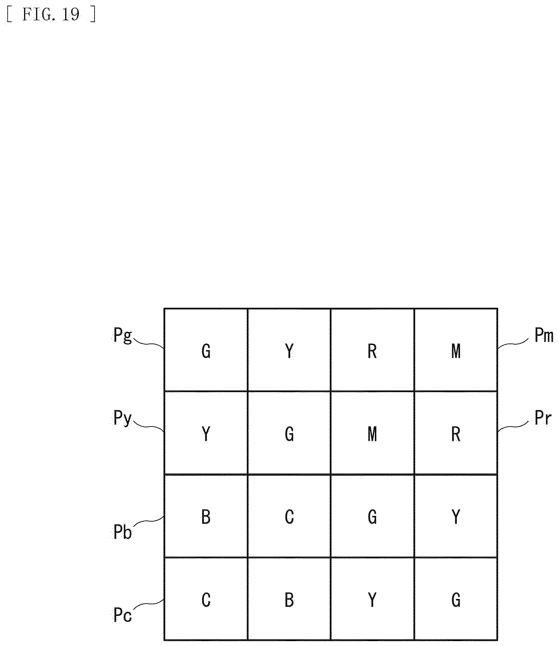

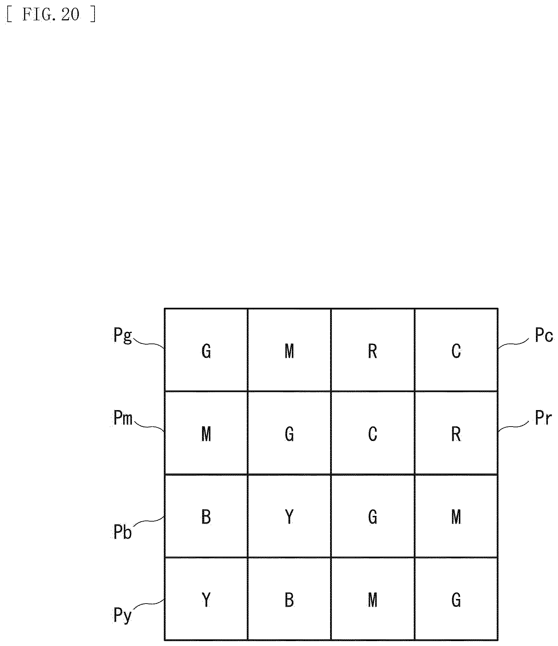

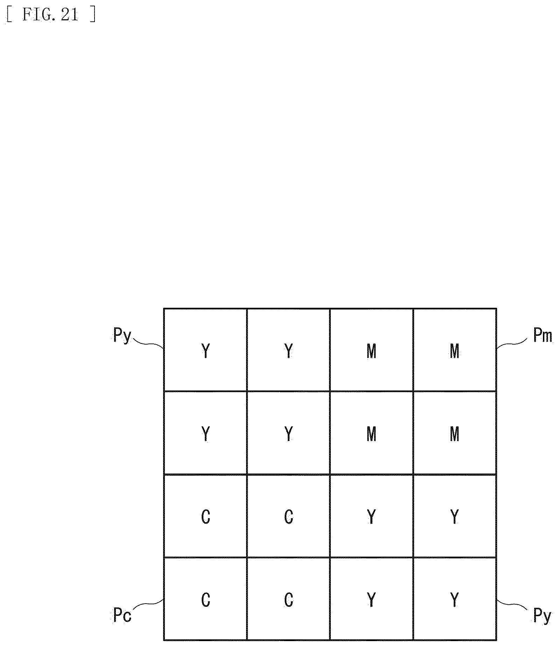

As with an example illustrated in FIG. 18, pixels Pw each having a W (white) color filter may be provided. Alternatively, as illustrated in FIG. 19 or FIG. 20, in addition to the pixels Pr, the pixels Pg, and the pixels Pb, pixels Pc each having a Cy (cyan) color filter, pixels Pm each having a Mg (magenta) color filter, and pixels Py each having a Ye (yellow) color filter may be arranged. It is to be noted that as illustrated in FIG. 21, four pixels Py in 2 × 2, four pixels Pm in 2 × 2, and four pixels Py in 2 × 2 may be repeatedly arranged.

### (2-6. Modification Example 6)

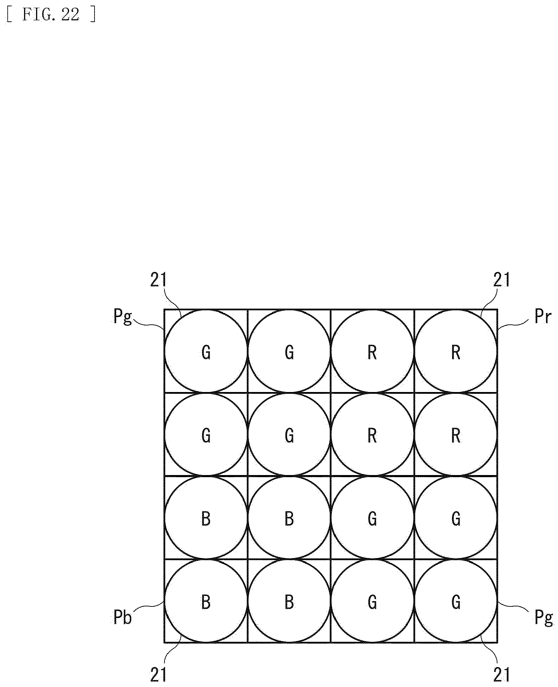

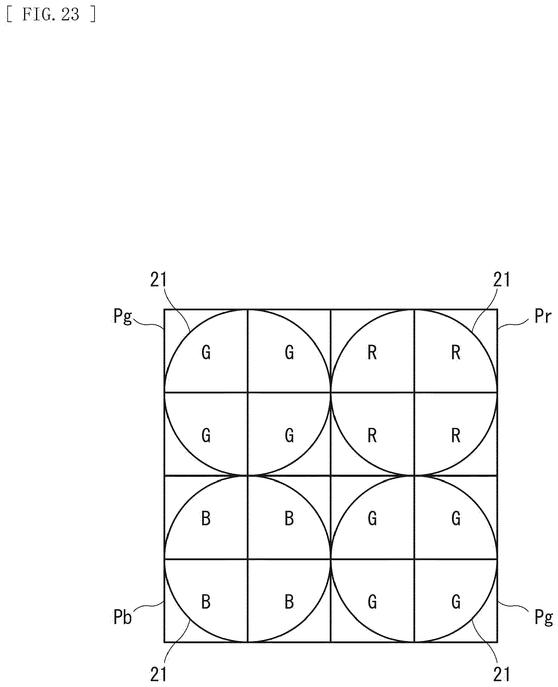

The arrangement of the lens sections 21 is also not limited to the example described above. For example, in a case where four pixels Pr in 2 × 2, four pixels Pg in 2 × 2, and four pixels Pb in 2 × 2 are arranged, as illustrated in FIG. 22, the lens section 21 may be provided for each pixel. Alternatively, as illustrated in FIG. 23, the lens section 21 may be provided for every four pixels.

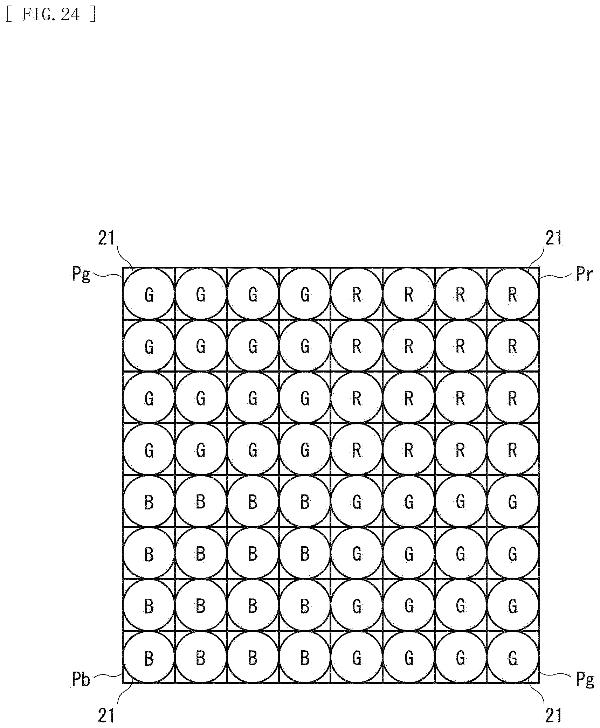

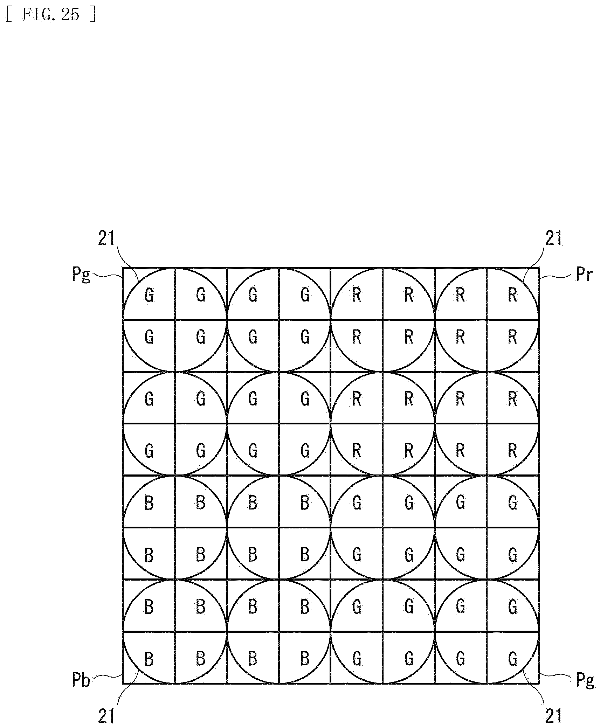

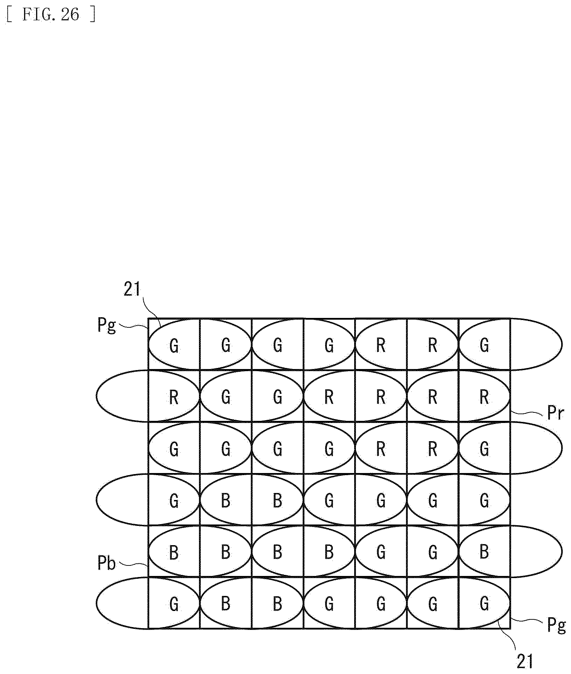

Alternatively, as illustrated in FIG. 24, in a case where sixteen pixels Pr in 4 × 4, sixteen pixels Pg in 4 × 4, and sixteen pixels Pb in 4 × 4 are arranged, the lens section 21 may be provided for each pixel. As illustrated in FIG. 25, the lens section 21 may be provided for every four pixels. It is to be noted that in a case where the pixels are arranged as with an example illustrated in FIG. 26, the lens section 21 may be provided for every 2 × 1 pixels.

### <3. Application Example>

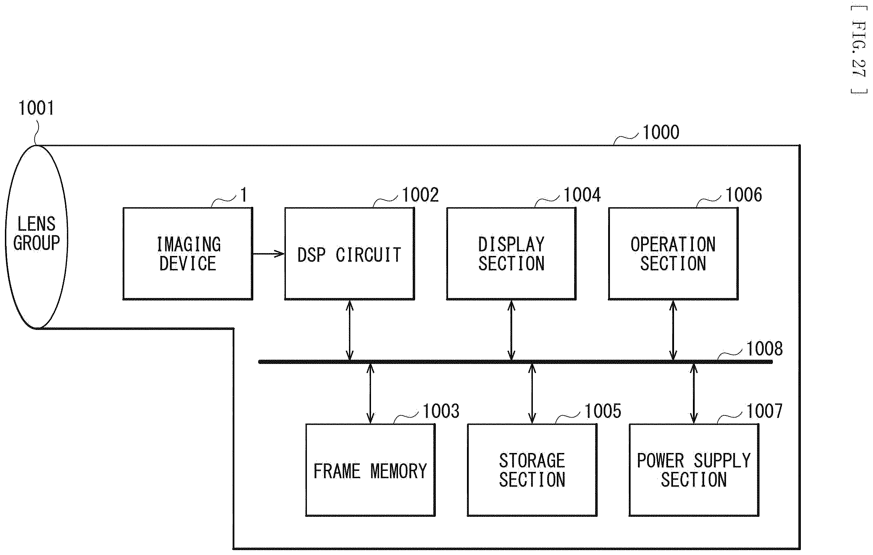

It is possible to apply the imaging device 1 or the like described above, for example, to a camera system such as a digital still camera or a video camera, a mobile phone or the like having an imaging function, and various types of electronic apparatuses having an imaging function. FIG. 27 illustrates a schematic configuration of an electronic apparatus 1000.

The electronic apparatus 1000 includes, for example, a lens group 1001, the imaging device 1, a DSP (Digital Signal Processor) circuit 1002, a frame memory 1003, a display section 1004, a storage section 1005, an operation section 1006, and a power supply section 1007, which are coupled to each other through a bus line 1008.

The lens group 1001 takes in incident light (image light) from a subject to form an image on an imaging plane of the imaging device 1. The imaging device 1 converts the light amount of the incident light of which the image is formed on the imaging plane through the lens group 1001 into electric signals on a pixel-by-pixel basis, and supplies the electric signals as pixel signals to the DSP circuit 1002.

The DSP circuit 1002 is a signal processing circuit that processes a signal supplied from the imaging device 1. The DSP circuit 1002 outputs image data obtained by processing the signal from the imaging device 1. The frame memory 1003 temporality holds the image data processed by the DSP circuit 1002 on a frame-by-frame basis.

The display section 1004 includes, for example, a panel-type display device such as a liquid crystal panel or an organic EL (Electro Luminescence) panel, and records image data of a moving image or a still image captured by the imaging device 1, on a recording medium such as a semiconductor memory or a hard disk.

In accordance with an operation by a user, the operation section 1006 outputs an operation signal concerning various functions of the electronic apparatus 1000. The power supply section 1007 supplies the DSP circuit 1002, the frame memory 1003, the display section 1004, the recording section 1005, and the operation section 1006 with various types of power as power for operating these supply targets as appropriate.

### <4. Practical Application Examples>

### (Practical Application Example to Mobile Body)

The technology according to the present disclosure (the present technology) is applicable to various products. For example, the technology according to the present disclosure may be achieved in the form of an apparatus to be mounted to a mobile body of any kind such as an automobile, an electric vehicle, a hybrid electric vehicle, a motorcycle, a bicycle, a personal mobility, an airplane, a drone, or a vessel, and a robot.

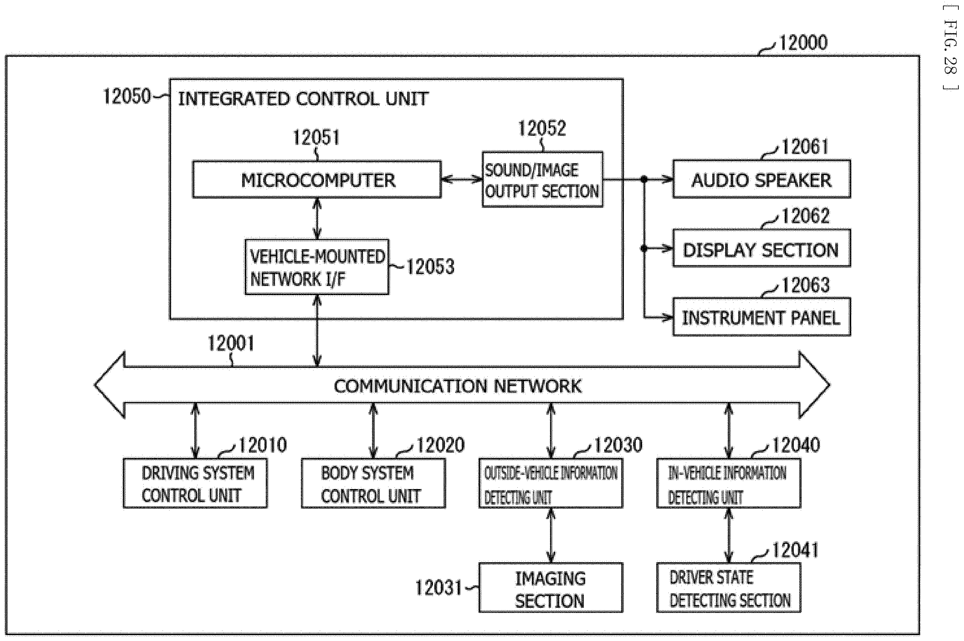

FIG. 28 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 28, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 28, an audio speaker 12061, a display section 12062, and an instrument panel 12063 are illustrated as the output device. The display section 12062 may, for example, include at least one of an on-board display and a head-up display.

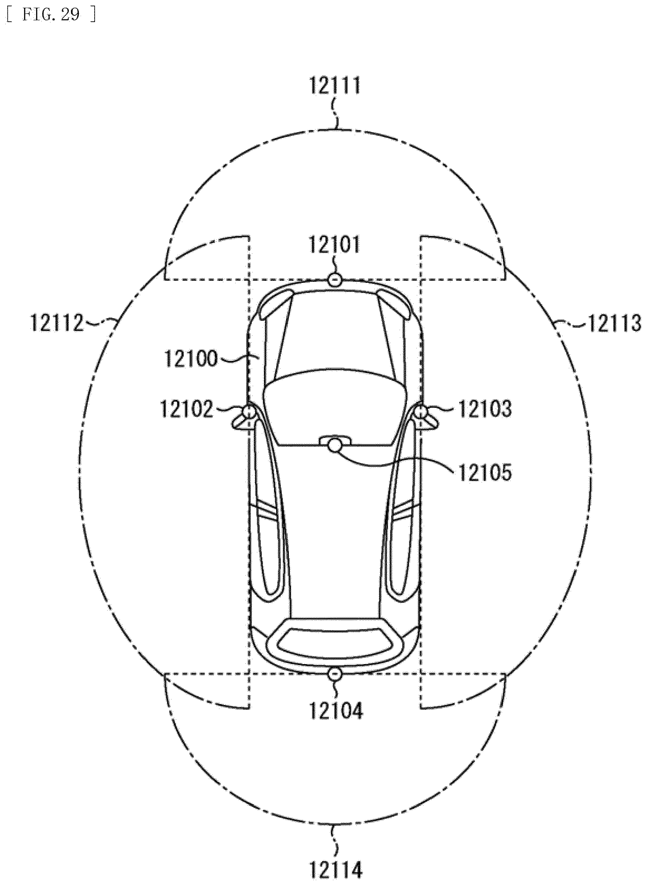

FIG. 29 is a diagram depicting an example of the installation position of the imaging section 12031.

In FIG. 29, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 29 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

One example of the vehicle control system to which the technology according to the present disclosure may be applied has been described above. The technology according to the present disclosure is appliable to, for example, the imaging section 12031 among the configurations described above. Specifically, the imaging device 1 is applicable to the imaging section 12031. Applying the technology according to the present disclosure to the imaging section 12031 makes it possible to obtain a high-definition shot image with less noise, and makes it possible to perform highly accurate control with use of the shot image in the mobile body control system.

### (Practical Application Example to Endoscopic Surgery System)

The technology according to the present disclosure (present technology) is applicable to various products. For example, the technology according to the present disclosure may be applied to an endoscopic surgery system.

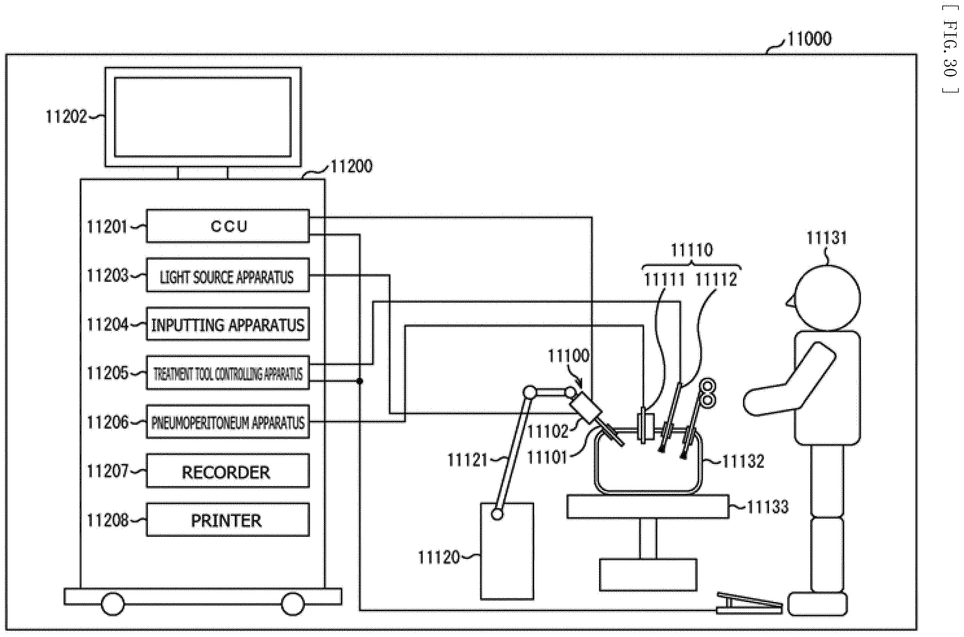

FIG. 30 is a view depicting an example of a schematic configuration of an endoscopic surgery system to which the technology according to an embodiment of the present disclosure (present technology) can be applied.

In FIG. 30, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

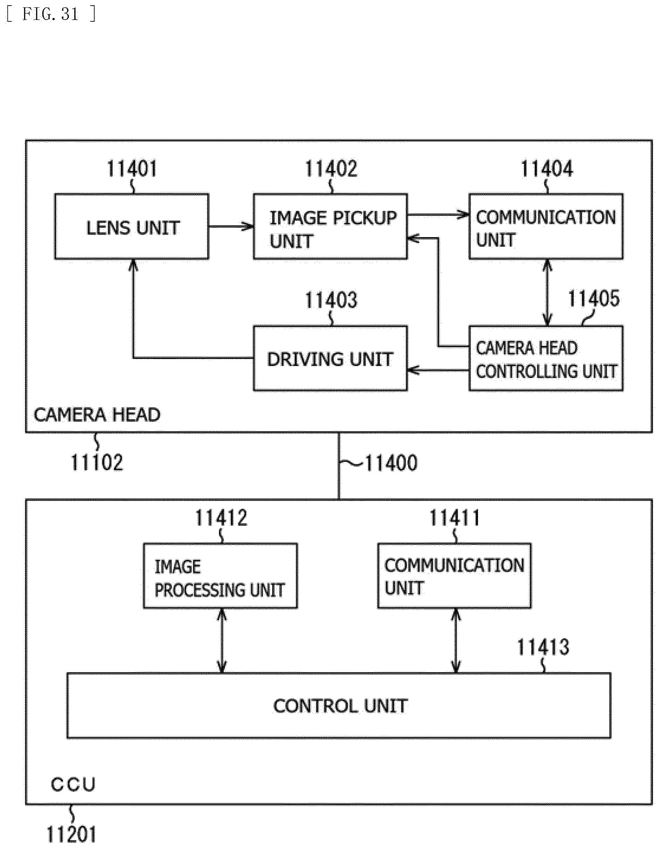

FIG. 31 is a block diagram depicting an example of a functional configuration of the camera head 11102 and the CCU 11201 depicted in FIG. 30.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

One example of the endoscopic surgery system to which the technology according to the present disclosure may be applied has been described above. The technology according to the present disclosure may be applied to, for example, the image pickup unit 11402 provided on the camera head 11102 of the endoscope 11100 among the configurations described above. Applying the technology according to the present disclosure to the image pickup unit 11402 makes it possible to increase sensitivity of the image pickup unit 11402 and makes it possible to provide the high-definition endoscope 11100.

Although the present disclosure has been described above with reference to the embodiment, the modification examples, the application example, and the practical application examples, the present technology is not limited to the embodiment and the like described above, and may be modified in a variety of ways. For example, the modification examples described above have been described as modification examples of the embodiment described above; however, configurations of the respective modification examples may be combined as appropriate. For example, the present disclosure is not limited to a back-illuminated image sensor, and is also applicable to a front-illuminated image sensor.

It is to be noted that the effects described herein are merely illustrative and non-limiting, and there may be other effects. In addition, the present disclosure may have the following configurations.
(1) An imaging device including:
   a first filter that allows light of a first wavelength band to pass therethrough;
   a first photoelectric converter that photoelectrically converts the light of the first wavelength band having passed through the first filter;
   a second filter that is provided adjacent to the first filter, and allows light of a second wavelength band to pass therethrough; and
   a second photoelectric converter that photoelectrically converts the light of the second wavelength band having passed through the second filter, in which
   a refractive index of the first filter for the light of the first wavelength band is higher than a refractive index of the second filter for the light of the first wavelength band.
(2) The imaging device according to (1), in which
   the first wavelength band includes a wavelength of green light, and
   the second wavelength band includes a wavelength of red light or a wavelength of blue light.
(3) The imaging device according to (1) or (2), in which the first wavelength band includes a wavelength band from 500 nm to 550 nm.
(4) The imaging device according to any one of (1) to (3), in which in the wavelength band from 500 nm to 550 nm, the refractive index of the first filter is higher by 0.05 or more than the refractive index of the second filter.
(5) The imaging device according to any one of (1) to (4), including:
   a third filter that is provided adjacent to the second filter, and allows light of a third wavelength band to pass therethrough; and
   a third photoelectric converter that photoelectrically converts the light of the third wavelength band having passed through the third filter, in which
   the refractive index of the first filter for the light of the first wavelength band is higher than a refractive index of the third filter for the light of the first wavelength band.
(6) The imaging device according to (5), in which
   the first wavelength band includes a wavelength of green light,
   the second wavelength band includes a wavelength of red light, and
   the third wavelength band includes wavelength of blue light.
(7) The imaging device according to (5) or (6), in which the first wavelength band includes a wavelength band from 500 nm to 550 nm.
(8) The imaging device according to any one of (5) to (7), in which in the wavelength band from 500 nm to 550 nm, the refractive index of the first filter is higher by 0.05 or more than the refractive index of the second filter, and is higher by 0.05 or more than the refractive index of the third filter.
(9) The imaging device according to any one of (5) to (8), in which the third wavelength band includes a wavelength band from 430 nm to 480 nm.
(10) The imaging device according to any one of (5) to (9), in which in the wavelength band from 430 nm to 480 nm, the refractive index of the third filter is higher by 0.05 or more than the refractive index of the second filter.
(11) The imaging device according to any one of (5) to (10), in which in a wavelength band from 400 nm to 700 nm, each of the refractive index of the first filter, the refractive index of the second filter, and the refractive index of the third filter is higher than a refractive index of silicon dioxide (SiO₂).
(12) The imaging device according to any one of (5) to (11), in which in the wavelength band from 400 nm to 700 nm, each of the refractive index of the first filter, the refractive index of the second filter, and the refractive index of the third filter is higher by 0.05 or more than the refractive index of silicon dioxide (SiO₂).
(13) The imaging device according to any one of (1) to (12), including an isolator provided between the first filter and the second filter.
(14) The imaging device according to (13), in which each of the refractive index of the first filter and the refractive index of the second filter is higher by 0.4 or more than a refractive index of the isolator.
(15) The imaging device according to (13) or (14), in which
   a substrate is provided in which a plurality of photoelectric converters including the first photoelectric converter and the second photoelectric converter is provided,
   the first filter and the second filter are provided on the substrate, and
   the isolator reaches at least to the substrate.
(16) The imaging device according to any one of (1) to (15), including a lens where light enters, in which
   the first photoelectric converter photoelectrically converts light having passed through the lens and the first filter, and
   a refractive index of the lens is higher than a refractive index of silicon dioxide (SiO₂).
(17) The imaging device according to any one of (1) to (16), including a fixed electric charge film and an antireflective film provided between the first filter and the first photoelectric converter.

This application claims the priority on the basis of Japanese Patent Application No. 2021-165691 filed on October 7, 2021 with Japan Patent Office, the entire contents of which are incorporated in this application by reference.

It should be understood by those skilled in the art that various modifications, combinations, subcombinations, and alterations may occur depending on design requirements and other factors insofar as they are within the scope of the appended claims or the equivalents thereof.

## Claims

1. An imaging device comprising:
a first filter that allows light of a first wavelength band to pass therethrough;
a first photoelectric converter that photoelectrically converts the light of the first wavelength band having passed through the first filter;
a second filter that is provided adjacent to the first filter, and allows light of a second wavelength band to pass therethrough; and
a second photoelectric converter that photoelectrically converts the light of the second wavelength band having passed through the second filter, wherein
a refractive index of the first filter for the light of the first wavelength band is higher than a refractive index of the second filter for the light of the first wavelength band.

2. The imaging device according to claim 1, wherein
the first wavelength band includes a wavelength of green light, and
the second wavelength band includes a wavelength of red light or a wavelength of blue light.

3. The imaging device according to claim 2, wherein the first wavelength band includes a wavelength band from 500 nm to 550 nm.

4. The imaging device according to claim 3, wherein in the wavelength band from 500 nm to 550 nm, the refractive index of the first filter is higher by 0.05 or more than the refractive index of the second filter.

5. The imaging device according to claim 1, comprising:
a third filter that is provided adjacent to the second filter, and allows light of a third wavelength band to pass therethrough; and
a third photoelectric converter that photoelectrically converts the light of the third wavelength band having passed through the third filter, wherein
the refractive index of the first filter for the light of the first wavelength band is higher than a refractive index of the third filter for the light of the first wavelength band.

6. The imaging device according to claim 5, wherein
the first wavelength band includes a wavelength of green light,
the second wavelength band includes a wavelength of red light, and
the third wavelength band includes a wavelength of blue light.

7. The imaging device according to claim 6, wherein the first wavelength band includes a wavelength band from 500 nm to 550 nm.

8. The imaging device according to claim 7, wherein in the wavelength band from 500 nm to 550 nm, the refractive index of the first filter is higher by 0.05 or more than the refractive index of the second filter, and is higher by 0.05 or more than the refractive index of the third filter.

9. The imaging device according to claim 6, wherein the third wavelength band includes a wavelength band from 430 nm to 480 nm.

10. The imaging device according to claim 9, wherein in the wavelength band from 430 nm to 480 nm, the refractive index of the third filter is higher by 0.05 or more than the refractive index of the second filter.

11. The imaging device according to claim 5, wherein in a wavelength band from 400 nm to 700 nm, each of the refractive index of the first filter, the refractive index of the second filter, and the refractive index of the third filter is higher than a refractive index of silicon dioxide (SiOz).

12. The imaging device according to claim 11, wherein in the wavelength band from 400 nm to 700 nm, each of the refractive index of the first filter, the refractive index of the second filter, and the refractive index of the third filter is higher by 0.05 or more than the refractive index of silicon dioxide (SiOz).

13. The imaging device according to claim 1, comprising an isolator provided between the first filter and the second filter.

14. The imaging device according to claim 13, wherein each of the refractive index of the first filter and the refractive index of the second filter is higher by 0.4 or more than a refractive index of the isolator.

15. The imaging device according to claim 13, wherein
a substrate is provided in which a plurality of photoelectric converters including the first photoelectric converter and the second photoelectric converter is provided,
the first filter and the second filter are provided on the substrate, and
the isolator reaches at least to the substrate.

16. The imaging device according to claim 1, comprising a lens where light enters, wherein
the first photoelectric converter photoelectrically converts light having passed through the lens and the first filter, and
a refractive index of the lens is higher than a refractive index of silicon dioxide (SiOz).

17. The imaging device according to claim 1, comprising a fixed electric charge film and an antireflective film provided between the first filter and the first photoelectric converter.
